Europäisches Patentamt

European Patent Office

Office européen des brevets

(11) Publication number: **0 397 014**
**A2**

# EUROPEAN PATENT APPLICATION

(21) Application number: **90108286.7**

(22) Date of filing: **01.05.90**

(51) Int. Cl.5: **H01L 29/784, H01L 29/10,**
**H01L 29/167, H01L 27/092,**
**H01L 21/74**

(30) Priority: **10.05.89 US 349606**

(43) Date of publication of application:
**14.11.90 Bulletin 90/46**

(84) Designated Contracting States:
**DE FR GB IT NL**

(71) Applicant: **NATIONAL SEMICONDUCTOR
CORPORATION**
**2900 Semiconductor Drive P.O. Box 58090
Santa Clara California 95051-8090(US)**

(72) Inventor: **Jennings, Dean Cook
1476 Mallard Way
Sunnyvale CA.(US)**

(74) Representative: **Sparing Röhl Henseler
Patentanwälte European Patent Attorneys
Rethelstrasse 123
D-4000 Düsseldorf 1(DE)**

(54) **Aluminium/Boron P-Well.**

(57) An integrated circuit is disclosed which includes at least one NMOS transistor having a P-well formed in an N-type epitaxial layer, the P-well being formed of a first, relatively high diffusivity P-type dopant and a second, relatively lower diffusivity P-type dopant, the dopants being diffused into the N-type epitaxial layer to form an effective P-well junction with the N-type epitaxial layer at a predetermined depth. A lower region of the P-well preferably contains a relatively higher concentration of electrically-active ions of the first P-type dopant and an upper region of the P-well contains a relatively higher concentration of electrically-active ions of the second P-type dopant, the effective P-well junction depth being determined by the first P-type dopant. A P-type layer may be situated below the N-type epitaxial layer, with the effective upper boundary of an N+ buried layer located at a predetermined distance below the P-well junction depth, whereby a region of the N-type epitaxial layer situated between the effective P-well junction and the N+ buried layer defines a depletion region of sufficient depth to support a predetermined reverse-bias voltage. The first P-type dopant is preferably Aluminum and the second P-type dopant is preferably Boron.

The P-well preferably comprises an N-type region of implanted at an energy of about 180 KeV with Aluminum ions at a concentration of $4 \times 10^{13}$ - $7 \times 10^{13}$ cm$^{-3}$, implanted at an energy of 50-100 Kev with Boron ions at a concentration of $4 \times 10^{11}$ - $1 \times 10^{13}$ cm$^{-3}$, and diffused for about 170 minutes at a temperature of about 1150 °C. The P-well formed in accordance with the invention may be advantageously used in monolithic circuits having DMOS and CMOS circuit elements for control and switching of relatively high voltages, such as 80 volts.

FIG.8

This invention relates to the fabrication of semiconductor integrated circuits, and in particular to the fabrication of P-wells in N-channel MOSFET devices.

A P-well is necessary to provide a P-type region in which to form the N-type source and drain of an N-channel MOSFET when such a transistor is fabricated in an N-type substrate or epitaxial layer. N-channel MOSFETs are often fabricated in an N-type substrate or epitaxial layer in a CMOS fabrication process. P-wells are typically boron-implanted regions which are subsequently diffused to a sufficient depth that N-channel MOSFETs can be fabricated in them.

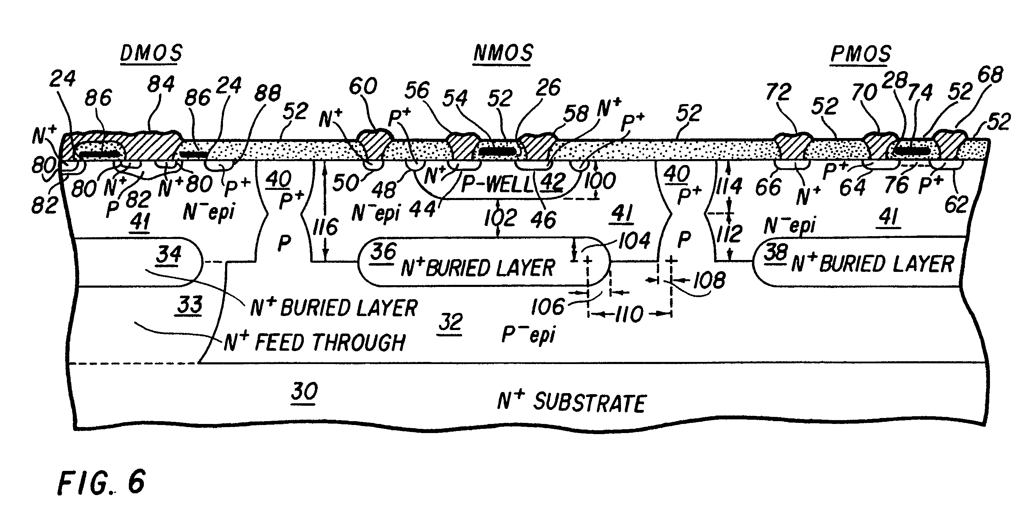

In a known process for the fabrication of monolithic "smart power" circuits (which include CMOS and DMOS FETs), a high concentration of an N-type dopant such as Arsenic or Phosphorus is ion-implanted into a P-type silicon substrate or epitaxial layer, and then diffused into the silicon at high temperature to form an N+ buried layer. An N-type epitaxial layer is subsequently grown over the N+ buried layer. Then a P-type dopant such as Boron is ion-implanted in the N-type epitaxial layer and driven in (diffused) at high temperature to form the P-well. The general structure resulting from such a process is similar in many respects to that of the preferred embodiment of the present invention illustrated in Figure 6. In Figure 6, a P-type epitaxial layer is shown at 32, N+ buried layer regions are shown at 34, 36 and 38, an N-type epitaxial layer is shown at 41, and a P-well is shown at 42.

Dopants in the silicon diffuse whenever the silicon is subjected to high-temperature processing. Thus, as the P-well is driven downwardly, the N+ buried layer diffuses upwardly toward the P-well. Upward diffusion of the N+ buried layer reduces the effective thickness of the N-type epitaxial layer, reducing the voltage which can be supported between the P-well and the N+ buried layer. A thicker N-type epitaxial layer must therefore be used to compensate for the upward diffusion of the N+ buried layer. However a thicker epitaxial layer is undesirable because it is relatively expensive to produce and because isolation between circuit elements becomes more difficult and costly to implement.

To isolate the circuit elements on a single substrate, a high concentration of P-type to dopant is diffused into the silicon surrounding each element to form P+ isolation rings surrounding the element. If the thickness of the N-type epitaxial layer is increased to compensate for upward diffusion of the N+ buried layer, the increased diffusion time required for the P+ isolation to extend vertically through the epitaxial layer means that the P+ isolations rings become wider laterally. The result is not only a more time-consuming the costly process, but also an integrated circuit which occupies a greater surface area of the substrate, Moreover, the epi-iso capacitance of the completed transistor at the junction of the N-type epitaxial layer with the P-type isolation regions increases with increased thickness of the N-type epitaxial layer, reducing the operating speed of the integrated circuit.

It is known to produce a P-well using atoms of an impurity having three valence electrons, such as Boron. It is also known that other trivalent atoms, such as those of Aluminum, may be used as P-type dopants in silicon.

Aluminum has the advantage as a dopant of greater diffusivity than Boron, and will thus diffuse deeper into the epitaxial layer than Boron dopant under a given set of processing conditions. However, Aluminum dopant has the disadvantage that it behaves less predictably than Boron dopant in the surface region where the MOS transistor is built. With Aluminum as a dopant, it is believed that only about 1 part in 15 of the implanted impurity remains electrically active after processing. The remainder becomes electrically inactive, perhaps because it becomes interstitial or perhaps because it reacts with available oxygen from formation of the oxide layer above the P-well to produce $Al_2O_3$ or some other complex inside the silicon.

For these and perhaps other reasons, controlling the effective concentration of Aluminum at the surface is difficult, and the amount of Aluminum which becomes electrically inactive is dependent on process parameters. Thus Aluminum has not been considered an ideal dopant for P-well formation.

U.S. Patent No. 4,746,964 to Aronowitz does, however, teach use of Aluminum and Boron dopants in combination for purposes of controlling their diffusion depth, and in particular for reducing the diffusion depth under a given set of processing parameters in comparison with Boron dopant alone. The teaching of that patent is directed to formation of P+ source and drain regions having P- carrier concentrations on the order of $10^{19}$ cm$^{-3}$ diffused to a depth of about $\frac{1}{2}$ $\mu$. By implanting relatively large doses of Boron and Aluminum dopants on the order of $4$-$6 \times 10^{15}$ cm$^{-3}$, and annealing at relatively low temperatures on the order of $700°$C - $900°$C for relatively short times up to 60 minutes, the Aronowitz teaching aims to reduce the diffusion depth of the P-carriers by as much as $\frac{1}{4}$ $\mu$. In contrast, and as defined in the independent claims, the present invention is directed to the combined use of preferably Aluminum and preferably Boron dopants in significantly smaller doses diffused to produce a P-well by employing significantly greater diffusion times and temperatures than the values taught in the Aronowitz patent.

The invention provides the following advantages alone or in combination.

A P-well which can be diffused to a selected depth with reduced processing time and/or temperature relative to P-wells produced conventionally with Boron as a dopant.

A P-well may be diffused to a desired depth while minimizing upward diffusion of the N+ buried layer in a given fabrication process.

A P-well may reduce the required epitaxial layer thickness for any given P-well to buried-layer breakdown voltage requirement by reducing buried layer up-diffusion.

The reduced the epitaxial layer thickness permits to reduce isolation space requirements.

A P-well allows reduced junction capacitance between the epitaxial layer and the isolation in a MOSFET.

These and other objects may be accomplished in accordance with the teachings of the present invention.

In a preferred embodiment of the invention, an integrated circuit is produced which includes at least one NMOS transistor having a P-well formed in an N-type epitaxial layer, the P-well being formed of a first, relatively high diffusivity P-type dopant and a second, relatively lower diffusivity P-type dopant, the dopants being diffused into the N-type epitaxial layer to form an effective P-well junction with the N-type epitaxial layer at a predetermined depth. A lower region of the P-well preferably contains a relatively higher concentration of electrically-active ions of the first P-type dopant and an upper region of the P-well contains a relatively higher concentration of electrically-active ions of the second P-type dopant, the effective P-well junction depth being determined by the first P-type dopant. A P-type layer may be situated below the N-type epitaxial layer, and the effective upper boundary of an N+ buried layer may be located at a predetermined distance below the P-well junction depth, whereby a region of the N-type epitaxial layer situated between the effective P-well junction and the N+ buried layer defines a depletion region of sufficient depth to support a predetermined reverse-bias voltage. The first P-type dopant is preferably Aluminum and the second P-type dopant is preferably Boron.

Figure 1 shows cross-sectional view of an N-type epitaxial region into which a P-well has been diffused in accordance with the invention;

Figure 2 is a plot illustrating qualitatively the impurity profile below the surface of the N-type epitaxial region taken along section line 2-2 of Figure 1;

Figure 3 is a plot of calculated values of impurity concentrations versus depth for a P-well formed by diffusion of Boron and Aluminum into an N⁻ epitaxial region in accordance with the invention;

Figure 4 is a plot of calculated values of impurity concentrations versus depth in an unacceptable P-well obtained by use of Boron alone as a P-type dopant, where the diffusion step is one which would produce an acceptable P-well with Aluminum and Boron used together as P-type dopants, for purposes of comparison with the plot of Figure 3;

Figure 5 is a plot of calculated values of impurity concentrations versus depth for a typical prior art P-well formed by diffusion of Boron into an N⁻ epitaxial region, for purposes of comparison with the plot of Figure 3;

Figure 6 shows a cross-sectional view of a portion of a monolithic DCMOS "smart power" circuit which may advantageously be produced in accordance with the teachings of the present invention;

Figure 7 is a plot of typical desired values of net carrier concentration versus depth for the NMOS P-well region of the circuit of Figure 6;

Figure 8 is a plot of calculated values of impurity and net carrier concentrations versus depth for the NMOS P-well region of the circuit of Figure 6, with the P-well formed by diffusion of Aluminum and Boron dopants in accordance with the present invention;

Figure 9 is a plot of calculated values of typical impurity and net carrier concentrations versus depth for a typical NMOS P-well region of a circuit such as that shown in Figure 6, with the P-well formed solely by diffusion of Boron dopant, for purposes of comparison with the plot of Figure 8.

The P-well of the present invention is intended for use in NMOS Field Effect Transistors (FETs), particularly those which are to be produced on a single substrate with PMOS FETs. It may also be used to build devices which include other types of MOSFETs on a single substrate. For example, it may be desired to build monolithic "smart power" circuits which include DMOS (double-diffused or vertical drain MOS) transistors for relatively high voltage power switching on a substrate with relatively lower voltage NMOS and or PMOS transistors used to control the power switching. It is desirable to fabricate such devices in a single, highly-integrated process which produces all of the transistors of the circuit, including the P-wells of the NMOS transistors.

In accordance with the invention, Aluminum and Boron are used as dopants to produce the P-wells. Using Aluminum in the P-well provides greater liberty in designing the process for a specific application. The greater diffusivity of Aluminum as compared with boron permits the attainment of a desired junction depth in a low time and temperature diffusion step, thereby minimizing buried-layer up-diffusion. The resulting larger depletion region is able to support greater breakdown voltage for any given diffusion process. Including Boron in the P-well offers greater control over the surface properties of the P-well region.

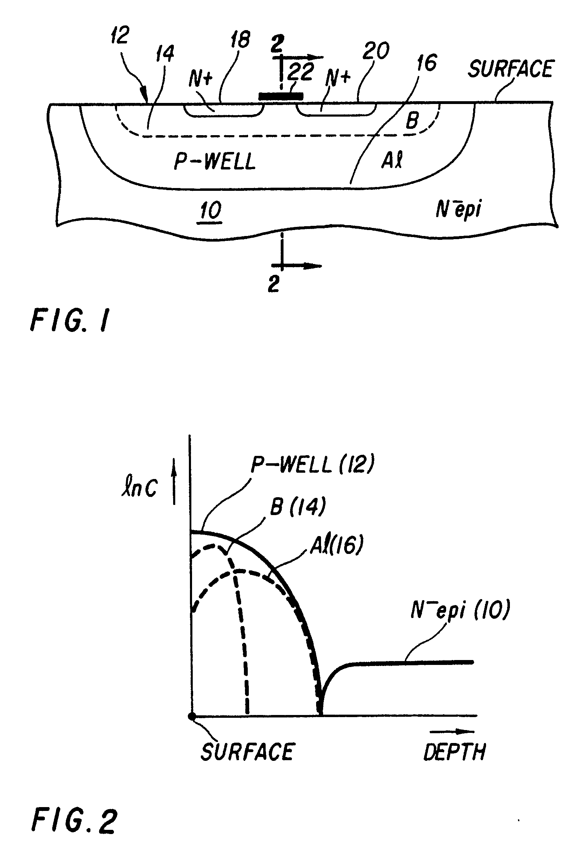

Figure 1 is a simplified, illustrative cross-sectional view of an N-type epitaxial region 10 into which a P-well 12 has been diffused in accordance with the invention. The P-well 12 is formed by ion-implantation and subsequent diffusion of Aluminum and Boron. Solid line 16 indicates the penetration of Aluminum and dashed line 14 indicates the penetration of Boron below the surface into the N-epitaxial region to define the P-well 12. After formation of the P-well, N+ source region 18 and N+ drain region 20 are formed in the upper portion of P-well 12 in a conventional manner, and gate region 22 is formed above P-well 12 in a conventional manner. Following addition of a conventional insulating oxide layer (not shown) on the surface of the substrate, contact regions (not shown) are added to complete the NMOS transistor.

Figure 2 is a plot illustrating qualitatively the impurity profile below the surface of the N-type epitaxial region taken along section line 2-2 of Figure 1. The log of impurity concentration is given alone the ordinate and the depth into the N-type epitaxial region from the surface is given along the abscissa. Impurity concentrations as shown are exaggerated with respect to those which would be used in practice, to illustrate their relative depths of penetration. The relative depths of penetration of the Aluminum and Boron dopants are a function of their relative diffusivity. Though the relationship is not linear, the Aluminum dopant is about twice as fast as the Boron dopant in diffusing into the silicon and forming a junction when implanted and diffused in accordance with the present invention. In the shallower region of the P-well, the Boron dopant contributes substantially more than the Aluminum dopant to the sum of the electrically active impurities. However, the relatively more rapid penetration of the Aluminum dopant causes the overall P-well to be much deeper than would be the case with the Boron dopant alone.

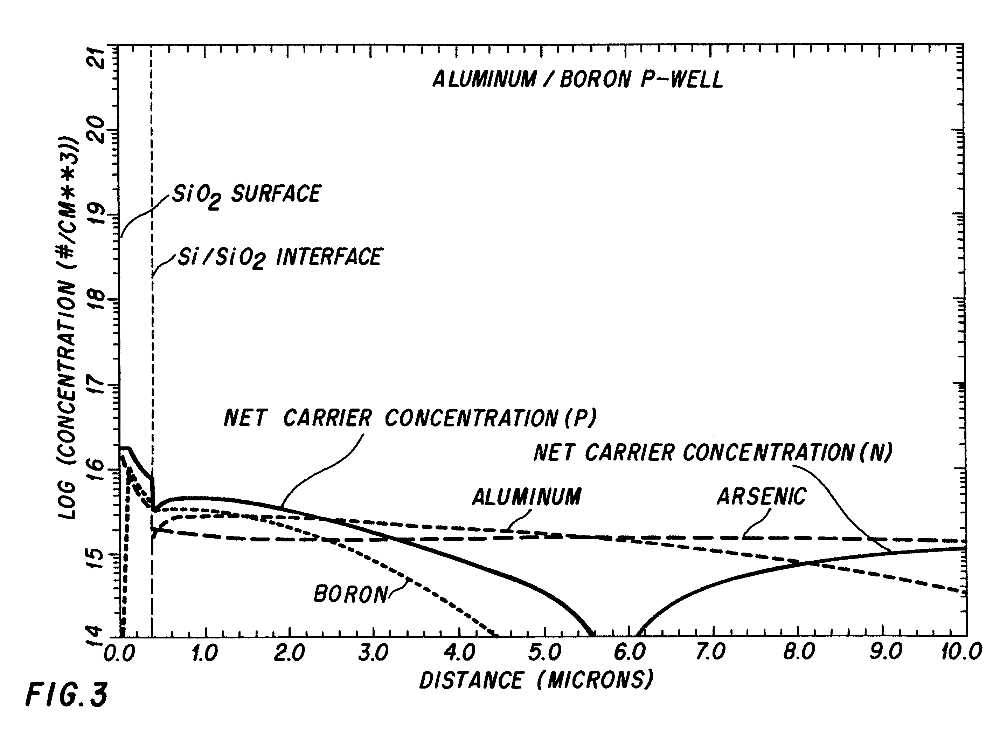

Figures 3-5 are plots of the log of concentration of impurities versus depth for P-wells formed by diffusion of P-type impurities into an N-type epitaxial region. The N-type epitaxial region may be grown on a P-type silicon substrate or on a P-type epitaxial layer of, for example, $15\mu$ thickness. For purposes of the examples given below with reference to Figures 3-5, reference will be made to a P-type substrate.

Figure 3 is a plot of calculated values of impurity concentrations versus depth for a P-well formed by diffusion of Boron and Aluminum ions into an N-type epitaxial region. For purposes of calculating the illustrated values, the following parameters were assumed:

○ A P-type silicon substrate of 1-0-0 orientation is employed, having a Boron ion impurity concentration of $2.0 \times 10^{15}$ cm$^{-3}$;

○ An N-type epitaxial layer of 1-0-0 orientation and having an Arsenic ion impurity concentration of $1.5 \times 10^{15}$ cm$^{-3}$ is deposited on the substrate to a thickness of $15.5\mu$;

○ Aluminum ions are implanted at a dosage of $3 \times 10^{13}$ cm$^{-3}$ at 180KeV (achieving an effective dosage of $2 \times 10^{12}$ cm$^{-3}$, since only about 1/15 of the implanted Aluminum ions would become electrically active);

○ Boron ions are implanted at a dosage of $1 \times 10^{12}$ cm$^{-3}$ at 70 KeV; and

○ The implants are diffused 300 minutes at 1150°C in a dry $O_2$ environment, followed by a 90-minute temperature ramp-down to 850°C in a Nitrogen environment.

As shown in Figure 3, the Boron ions diffuse to a depth of about 4.5 $\mu$, while the effective Aluminum ion concentration extends beyond $10\mu$, yielding a net carrier concentration (P) depth for the P-well of about $5.6\mu$. Below about $6.0\mu$ the net carrier concentration (N) is that of the N-type epitaxial region underlying the P-well. The indicated depths are given from the upper surface of the silicon oxide layer overlying the N-type epitaxial layer. The oxide layer has a thickness of 3.65 kÅ.

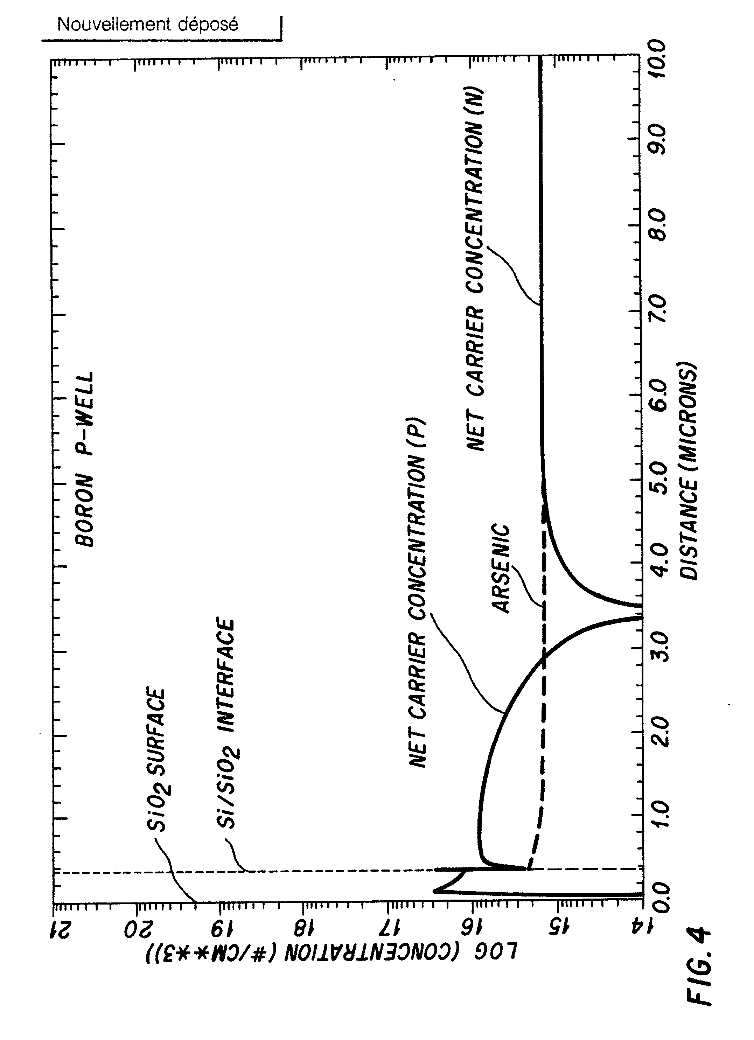

By way of comparison, Figure 4 is a plot of calculated values of impurity concentrations versus depth for a prior art P-well formed solely by diffusion of Boron into an N-type epitaxial region formed on a substrate. For purposes of calculating the illustrated values, the following parameters were assumed:

○ A P-type silicon substrate of 1-0-0 orientation is employed, having a Boron ion impurity concentration of $2.0 \times 10^{15}$ cm$^{-3}$;

○ An N-type epitaxial layer of 1-0-0 orientation and having an Arsenic ion impurity concentration of $1.5 \times 10^{15}$ cm$^{-3}$ is deposited on the substrate to a thickness of $15.5\mu$;

○ Boron ions are implanted at a dosage of $3.0 \times 10^{12}$ cm$^{-3}$ at 70 KeV;

○ The implant is diffused 300 minutes at 1150°C in a dry $O_2$ environment, followed by a 90-minutes temperature ramp-down to 850°C in a Nitrogen environment.

As shown in Figure 4, the Boron ions diffuse to a depth of only about 3.4 $\mu$, much less than the depth obtained under similar processing conditions when using both Aluminum and Boron as dopants. The indicated depth is given from the surface of the oxide layer overlying the N-type epitaxial layer. The oxide layer has a thickness of 3.4 kÅ.

The diffusion used in the example of Figure 4 is inadequate for a P-well formed using solely Boron as the P-type dopant. It illustrates the unacceptable P-well which would result from using solely Boron as a dopant with a diffusion step which could produce an acceptable P-well when Aluminum and Boron are used together as P-type dopants in accordance with the invention.

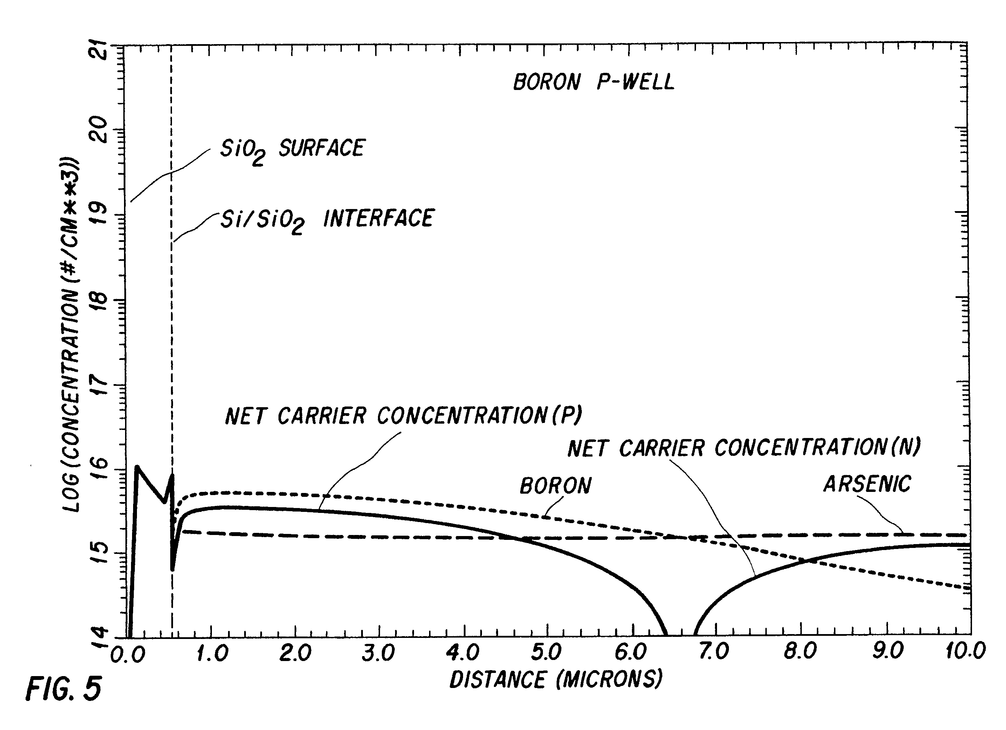

Further by way of comparison, Figure 5 is a plot of calculated values of impurity concentrations versus depth for a typical prior art P-well formed by diffusion of Boron into an N-type epitaxial region formed on a substrate. The example of Figure 5 illustrates that much greater diffusion temperature and time could be used to achieve a P-well depth comparable to that of Figure 3. For purposes of calculating the illustrated values, the following parameters were assumed:

O A P-type silicon substrate of 1-0-0 orientation is employed, having a Boron ion impurity concentration of $2.0 \times 10^{15}$ $cm^{-3}$;

O An N-type epitaxial layer of 1-0-0 orientation and having an Arsenic ion impurity concentration of $1.5 \times 10^{15}$ $cm^{-3}$ is deposited on the substrate to a thickness of $15.5\mu$;

O Boron ions are implanted at a dosage of $3.0 \times 10^{12}$ $cm^{-3}$ at 70 KeV;

O The implant is diffused 270 minutes at $1270°C$ in a dry $O_2$ environment, followed by a 110-minute temperature ramp-down to $850°C$ in a Nitrogen environment.

As shown in Figure 5, the Boron dopant would diffuse to beyond $10\mu$ depth, yielding a net carrier concentration (P) for the P-well to a depth of about $6.4\mu$. The indicated depth is given from the surface of the oxide layer overlying the N-type epitaxial layer. The oxide layer has a thickness of 5.5 kÅ.

Comparison of Figures 3 and 4 indicates that under comparable diffusion time and temperature conditions, use of Aluminum and Boron dopants in combination offers a significantly deeper P-well than does use of Boron dopant alone. Comparison of Figures 3 and 5 indicates that to obtain a P-well of comparable depth, the diffusion time and/or temperature must be substantially greater for Boron dopant alone than for Aluminum and Boron dopants in combination.

An example of the use of the present invention is shown in Figure 6, which includes an NMOS transistor, a PMOS transistor and a DMOS transistor formed on a single N+ type substrate 30. The figure shows a cross-sectional view of a portion of a silicon wafer in which the transistors are fabricated. The drawing is not to scale but is distorted, particularly in the vertical dimension, to more clearly show the various layers of the transistors. For example, the gate oxides 24, 26 and 28 are about 1000 Å thick or about 1/8 to 1/10 the thickness of the field oxide. Also, the area shown is around a group of transistors which comprises only a tiny fraction of a wafer. Such a wafer contains may complete circuits, each of which may contain many transistors.

Substrate 30 has a P-type epitaxial layer 32 grown thereon. A portion 33 of layer 32 is doped with a donor impurity to form an N-type feed-through region 33 for the DMOS elements. An N+ buried layer is implanted in feed-through region 33, and N+ buried layers 36 and 38 are implanted in P-type epitaxial layer 32. P+ isolation regions 40 pass through the N-type epitaxial layer 41 which overlies the P-type epitaxial region 32. The P+ isolation regions 40 are preferably formed by implantation and diffusion of a high dose, such as $1-5 \times 10^{14}$ $cm^{-3}$, of Aluminum ions as taught, for example, in U.S. Patent No. 4,512,816. Such use of Aluminum as a P-type dopant to form the P+ isolation regions 40 allows the process designer to take full advantage of the benefits of the Aluminum/Boron P-well formed in accordance with the present invention, and permits and P+ isolation regions 40 to be diffused in the same diffusion step as the P-well of the present invention.

To form the NMOS transistor, a P-well region 42 is formed by diffusing Aluminum and Boron into the N-epitaxial region 41 in accordance with the present invention. An N+ source region 44 and an N+ drain region 46 are diffused into the P-well 42 in conventional manner. A P+ ring 48 serving as a channel stop is diffused into the upper periphery of the junction between the P-well 42 and N-epitaxial region 41, also in conventional manner. An N+ epitaxial-contact region 50 is diffused into the N-epitaxial region 41 adjacent to the P-well 42. Gate oxide layer 26, a top gate 54 of polysilicon and a layer of passivating oxide 52 complete the NMOS transistor. Metal contact regions 56, 58 and 60 provide for electrical contact to the source, drain and N-type epitaxial layer, respectively, of the NMOS transistor. The polysilicon gate contact of the NMOS transistor is not shown.

To form the PMOS transistor, a P+ type source region 62, a P+ type drain region 64 and an N+ back gate contact region 66 are diffused into the N-type epitaxial layer 41. Respective metal contacts 68, 70, 72 provide for electrical contact to the source, drain and back gate of the completed PMOS transistor. A top gate 74 of polysilicon is provided above a gate oxide layer 28 which is in turn provide above an N-channel region 76 formed by ion implantation and/or diffusion in the region of the N-type epitaxial layer 41 lying between the source 62 and the drain 64. The structure of the PMOS FET is also shown as being completed by conventional passivating oxide 52.

The DMOS (otherwise sometimes preferred to as Large Vertical Drain MOS) transistor illustrated in Figure 6 is designed for switching of relatively high voltage, such as 80 volts. The DMOS transistor employs the lower surface of the N+ silicon substrate 30 as its drain. Its source consists of N+ regions 80 implanted in P-wells 82 diffused into the N-type epitaxial layer 41. Contact to the source is made by a metalized layer 84. Gate regions 86 are provided above a layer of gate oxide 24 overlying the N-type epitaxial layer, exiting from field oxide layer 52 in a region (not illustrated) where they may be electrically contacted. A P+ guard ring is diffused into the N-type epitaxial layer surrounding the source regions for the purpose of spreading the carrier-depletion region established in the diode formed by the N-type epitaxial layer and the surrounding P-type material when the DMOS transistor is in operation. The voltage which the DMOS transistor is capable of supporting for a given thickness of the N-type epitaxial layer is enhanced by the presence of the P+ guard ring.

In designing a process such as that illustrated in Figure 6, the thickness of the N-type epitaxial layer 41 is primarily determined by the desired reverse-bias breakdown voltage of the DMOS transistor. In reverse bias, the electric field created in the DMOS transistor is greatest at the junctions between the P-type regions and the N-type regions. The greater the applied reverse-bias voltage, the greater the electric field. The electric field decreases as a function of depth into the N-type epitaxial layer, since charges are depleted out of the N-type epitaxial layer, and the rate of decrease with depth is proportional to the dopant concentration in the N-type epitaxial layer. Junction breakdown should occur when the electric field depletes the N-type epitaxial layer down to the N+ buried layer.

If the N-type epitaxial layer is thicker than needed to support the desired breakdown voltage for the DMOS transistor, the internal resistance of the transistor will be greater than necessary, an undesirable characteristic in a power-switching transistor. Further, an N-type epitaxial layer which is thicker than required adds unnecessarily to the cost of the circuit because of the relatively high cost of growing the N-type epitaxial layer. Still further, an N-type epitaxial layer which is thicker than required increases the diffusion time and/or temperature needed for the P+ isolation regions to penetrate the N-type epitaxial layer, causing the P+ isolation regions 40 to expand more than desired in the lateral direction and thereby requiring more valuable space on the substrate than desired.

The ideal N-type epitaxial layer for the circuit illustrated in Figure 6 will have a dopant concentration and thickness such that critical electric field (about 30 volts/$\mu$ for silicon) will be reached at the DMOS P-N junction just as the electric field depletes the N-type epitaxial layer of the DMOS transistor down to the N+ buried layer of the DMOS transistor. However, if it is necessary to use relatively high temperature for a relatively long time to diffuse the NMOS P-well to an adequate depth for the desired NMOS characteristics, the N+ buried layer 34 of the DMOS transistor will diffuse upwardly more than desired, reducing the effective thickness of the N-type epitaxial layer more than desired, and the P+ isolation regions may diffuse laterally more than desired, increasing the lateral space required to form the circuit on the substrate.

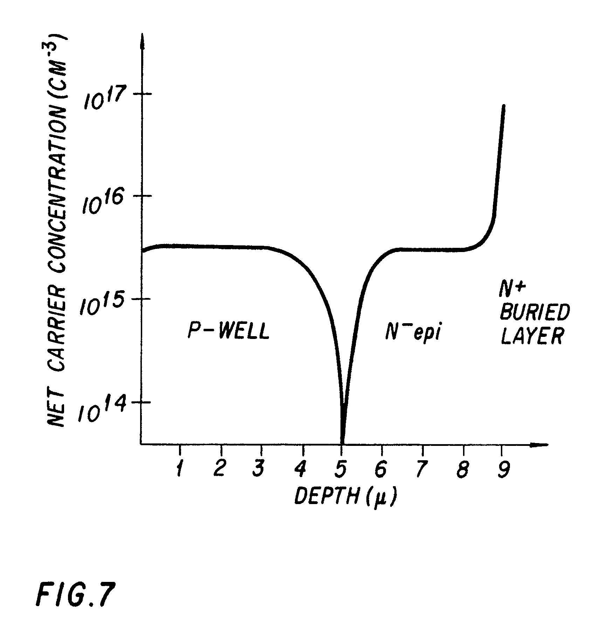

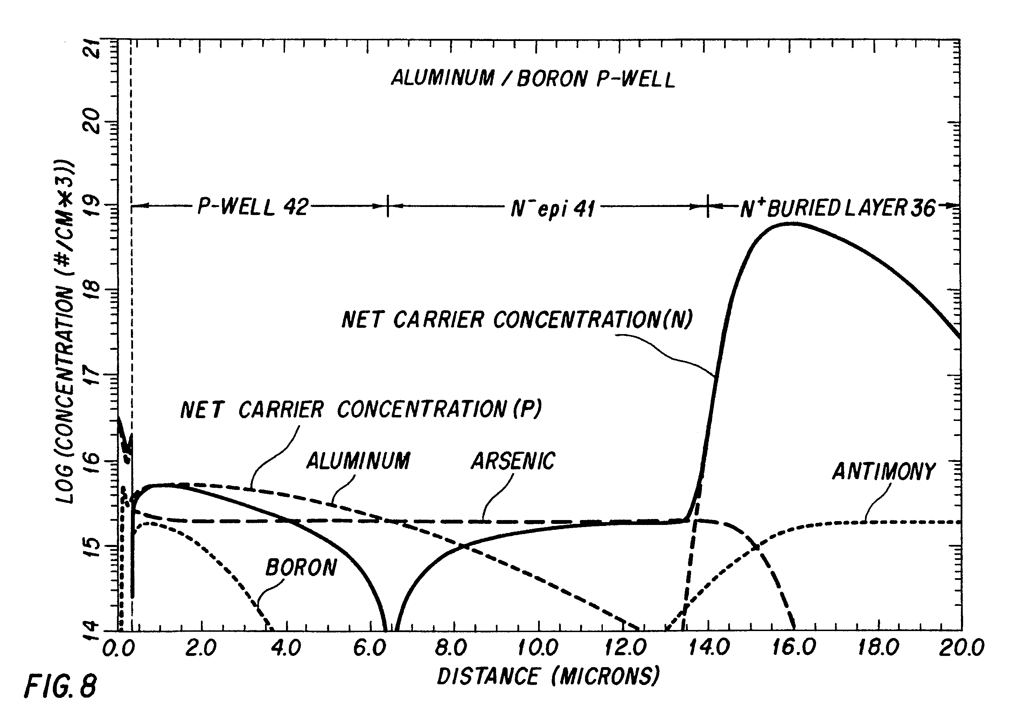

Figure 7 is a plot of typical desired values of net carrier concentration versus depth for the NMOS P-well region 42 of the circuit of Figure 6. As can be seen from Figures 6 and 7, a typical desired depth 100 for the P-well region 42 is about 5$\mu$, and a typical desired distance 102 from the P-well region 42 to the upper boundary of the N+ buried layer 36 is about 3$\mu$. In attaining these values, it is desired to realize upward diffusion 104 and lateral diffusion 106 of buried layers 34, 36 and 38 of about 4.5$\mu$. It is also desired to restrict the lateral diffusion distance 108 of the P+ isolation regions to about 6.7$\mu$ while the implanted P+ isolation dopant diffuses upwardly a distance 112 of about 7.5$\mu$ from the interface of the P-type epitaxial region and the N-type epitaxial region and diffuses downwardly a distance 114 of about 9$\mu$ from the upper surface of the N-type epitaxial region 41. The N-type epitaxial region 41 preferably has a thickness 110 of about 13$\mu$ and 2.5$\Omega \cdot$cm resistivity. The foregoing parameters are believed attainable employing a P-well 42 formed with Aluminum and Boron dopants in accordance with the present invention, for example using the P-well formation parameters discussed below with reference to Figure 8.

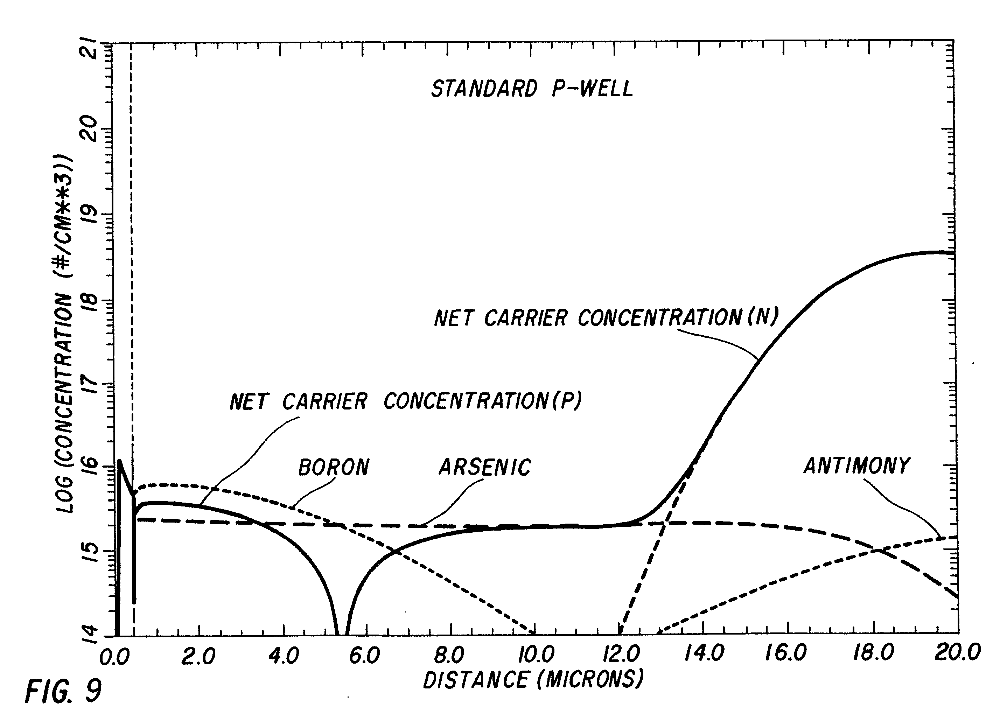

However, with a P-well 42 formed using Boron alone as a dopant in a typical prior art process (for example using parameters discussed above with reference to Figure 9), the increased diffusion time and temperature required for the P-well 42 to reach an effective depth of about 5$\mu$ is expected to result in upward diffusion 104 of buried layers 34, 36 and 38 of about 8$\mu$, lateral diffusion 106 of buried layers 34, 36 and 38 of about 7.2$\mu$, P+ isolation-up side diffusion distance 108 of about 10$\mu$, a P+ isolation upward diffusion distance 112 of about 10$\mu$ and a P+ isolation downward diffusion distance 114 of about 12$\mu$. As a result of the increased lateral diffusion of the P+ isolation regions and the N+ buried layers, the spacing 110 between ion implants for the P+ isolation 40 and the N+ buried layers 36, 36 and 38 must be increased by about 6$\mu$, making the entire circuit correspondingly larger. In addition, the N-type epitaxial layer thickness 116 must be increased to about 16$\mu$,

assuming a resistivity of 2.5Ω•cm, to compensate for the increased upward diffusion of the N+ buried layers.

Figure 8 is a plot of calculated values of impurity and net carrier concentrations versus depth for the NMOS P-well region of the circuit of Figure 6, with the P-well formed by diffusion of Aluminum and Boron dopants in accordance with the present invention. For purposes of calculating the illustrated values, the following parameters were assumed:

○ A P-type epitaxial layer 32 is grown on an N+ silicon substrate of 1-0-0 orientation, with the P-type layer 32 having a thickness of about 15μ and a Boron ion impurity concentration of $2.0 \times 10^{15}$ $cm^{-3}$;

○ Antimony ions are implanted in the P-type epitaxial layer 32 at a dosage of $2.0 \times 10^{15}$ $cm^{-3}$ at 80KeV to form the N+ buried layer regions, and then diffused 300 minutes at 1270°C in a dry $O_2$ environment, followed by a 110-minute temperature ramp-down to 850°C in a Nitrogen environment;

○ After etching of all surface oxide, an N-type epitaxial layer 41 of Silicon is deposited to a thickness of 15μ with 1-0-0 orientation, layer 41 having an Arsenic ion impurity concentration of $2.0 \times 10^{15}$ $cm^{-3}$;

○ Aluminum ions are implanted at a dosage of $5.25 \times 10^{13}$ $cm^{-3}$ at 180KeV (achieving an effective dosage of $3.5 \times 10^{12}$ $cm^{-3}$, since only about 1/15 of the implanted Aluminum ions are expected to become electrically active);

○ Boron ions are implanted at a dosage of $5 \times 10^{11}$ $cm^{-3}$ at 70 KeV;

○ The implants are diffused 240 minutes at 1150°C in a dry $O_2$ environment, followed by a 90-minute temperature ramp-down to 850°C in a Nitrogen environment.

As shown in Figure 8, the Boron ions would diffuse to a depth of about 3.7μ, while the effective Aluminum ion concentration would extend to a depth of about 12μ, yielding a net carrier concentration (P) depth for the P-well of about 6.4μ. From a depth of about 7μ to a depth of about 14μ the net carrier concentration (N) is that of the N-type epitaxial region 41, and below about 14μ the much higher net carrier concentration (N) is that of the N+ buried layer 36. The indicated depths are given from the surface of the oxide layer overlying the substrate, the oxide layer having a thickness of 3226 Å. As the depth of the P-well formed with these parameters would be slightly greater than the desired depth of 5μ, the diffusion time of 240 minutes at 1150°C may advantageously be reduced to about 170 minutes at 1150°C to attain the desired 5μ P-well depth.

Figure 9 is a plot of calculated values of typical impurity and net carrier concentrations versus depth for the NMOS P-well region of the circuit of Figure 6, with the P-well formed by diffusion of Boron dopant, for purposes of comparison with the plot of Figure 8. For purpose of calculating the illustrated values, the following parameters were assumed:

○ A P-type epitaxial layer 32 is grown on an N+ silicon substrate of 1-0-0 orientation, with the P-type layer 32 having a thickness of about 15μ and a Boron ion impurity concentration of $2.0 \times 10^{15}$ $cm^{-3}$;

○ Antimony ions are implanted in the P-type epitaxial layer 32 at a dosage of $2.0 \times 10^{15}$ $cm^{-3}$ at 80 KeV to form the buried layer regions, and then diffused 300 minutes at 1270°C in a dry $O_2$ environment, followed by a 110-minute temperature ramp-down to 850°C in a Nitrogen environment;

○ After etching of all surface oxide, an N-type epitaxial layer 41 of Silicon is deposited to a thickness of 15μ with 1-0-0 orientation, layer 41 having an Arsenic ion impurity concentration of $2.0 \times 10^{15}$ $cm^{-3}$;

○ Boron ions are implanted at a dosage of $3 \times 10^{12}$ $cm^{-3}$ at 70 KeV;

○ The implants are diffused 200 minutes at 1270°C in a dry $O_2$ environment, followed by a 90-minute temperature ramp-down to 850°C in a Nitrogen environment.

As shown in Figure 9, the Boron ions would diffuse to a depth of about 10μ, yielding a net carrier concentration (P) depth for the P-well of about 5.3μ. From a depth of about 5.5μ to a depth of about 13μ the net carrier concentration (N) is that of the N-type epitaxial region 41, and below about 13μ the much higher net carrier concentration (N) is that of the N+ buried layer 36. The indicated depths are given from the surface of the oxide layer overlying the substrate, the oxide layer having a thickness of 4703 Å. It can be seen that such a "standard" P-well formed using only Boron as a P-type dopant would require substantially higher diffusion temperature to achieve a P-well of the desired 5μ depth.

Because of the rapid penetration of the Aluminum dopant during diffusion of the P-well region 42, N+ buried layers 34, 36 and 38 will migrate upwardly much less than if Boron dopant alone were used to obtain the same P-well depth. As a result, the N-epitaxial layer 41 may be kept relatively thinner, reducing the surface area (and therefore the capacitance) at the junction of the N-epitaxial layer 41 to the P+ isolation regions 40. Faster-switching transistors may therefore be produced than would be the case with use of Boron dopant alone to form the P-well.

Moreover, the relatively thinner N-epitaxial layer reduces the diffusion time required for P+ isolations regions 40 to penetrate the N-epitaxial layer, resulting in less lateral diffusion of the P+ isolation regions and permitting fabrication of the transistors in a more compact area of the wafer.

Comparison of Figures 8 and 9 indicates that use of Aluminum as a dopant in combination with the Boron dopant in accordance with the invention to form the NMOS P-well enhances the depth of the P-well while reducing the diffusion time and/or temperature compared with that required for a P-well formed with Boron dopant alone. Use of the Boron dopant in combination with the Aluminum dopant assists in controlling properties at the upper surface of the P-well due to the greater propensity of the Aluminum ions to become electrically inactive, particularly due to the presence of oxygen in the oxide layer overlying the P-well.

Aluminum can advantageously be added as a dopant to an existing process which employs Boron in forming a P-well. Given an existing process using Boron alone, a designer may wish to increase the depth of the P-well junction with the underlying N-type epitaxial layer for a given diffusion time and temperature regime without significantly changing the surface concentration of P-type impurity. Using Aluminum as a dopant in combination with Boron permits attainment of the desired junction depth with low diffusion time and temperature. The buried-layer up-diffusion can be minimized, maintaining the desired P-well to buried-layer distance. The depletion region needed to support higher breakdown voltage is attained, but the Aluminum will not contribute appreciably to the electrically-active surface impurity concentration.

Thus, the Aluminum/Boron P-well in accordance with the invention can be used to reduce the lateral and vertical size of the circuit elements, reduce the fabrication process time (thereby reducing the cost) and allows fabrication of transistors of increased operating speed.

The following parameter ranges are preferred in forming a P-well in accordance with the present invention:

O Aluminum ions implanted at a relatively high energy, on the order of 100-200 KeV (most preferably about 180 KeV), at dosages within the range of $4 \times 10^{13}$ - $7 \times 10^{13}$ cm$^{-3}$ to achieve an expected electrically-active Aluminum ion yield of about 1/15 the implant dosage. Somewhat lower energies may also be used, provided that dosage is increased to account for the expected lower percentage yields of electrically-active Aluminum dopant.

O Boron ions implanted at 50-100 KeV at dosages within the range of $4 \times 10^{11}$ - $1 \times 10^{13}$ cm$^{-3}$. Most preferred are lower-dosage Boron ion implants made at about 70-80 KeV for higher voltage NMOS. Also, low doses cause less lattice damage to the silicon crystal than higher dosages implanted with lower energies.

O Boron and Aluminum ion implants may be made on a naked surface or through an oxide layer, and are most preferably made through a screen oxide layer which serves to reduce crystal lattice damage. Dosages are preferably increased as needed to compensate for presence of any oxide layer.

O Diffusion for 100-300 minutes at 1100-1200°C, preferably about 170 minutes at about 1150°C.

Those of skill in the art will recognize that many modifications to the above-described embodiments may be made without departing from the spirit and scope of the present invention. For example, it may be possible to achieve a higher yield of electrically-active Aluminum dopant under certain circumstances than the yield indicated herein, in which case the dosage of Aluminum may be correspondingly reduced. Further, the sequence of implanting the Boron and Aluminum dopants need not be carried out sequentially in the order given in the foregoing examples. Still further, the indicated diffusion times may be reduced to some extent with correspondingly greater diffusion temperatures, and vice versa. Diffusion may be carried out in sequential heating steps, rather than in a single step as described above. Still other modifications may be made within the scope of the invention defined by the following claims.

## Claims

1. An integrated circuit including at least one NMOS transistor having a P-well formed in an N-type epitaxial layer, said P-well being formed of a first, relatively high diffusivity P-type dopant and a second, relatively lower diffusivity P-type dopant, said dopants being diffused into said N-type epitaxial layer to form an effective P-well junction with said N-type epitaxial layer at a predetermined depth.

2. The integrated circuit of claim 1, wherein a lower region of said P-well contains a relatively high concentration of electrically-active ions of said first P-type dopant and an upper region of said P-well contains a relatively higher concentration of electrically-active ions of said second P-type dopant, said effective P-well junction depth being determined by said first P-type dopant.

3. The integrated circuit of claim 2, wherein a P-type layer is situated below said N-type epitaxial layer, and the effective upper boundary of an N+ buried layer is located at a predetermined distance below said P-well junction depth, whereby a region of said N-type epitaxial layer situated between said effective P-well junction and said N+ buried layer defines a depletion region of sufficient depth to support a predetermined reverse-bias voltage.

4. The integrated circuit of one of claims 1, 2 or 3 wherein said first P-type dopant comprises Aluminum and said second P-type dopant comprises Boron.

5. The integrated circuit of claim 4, wherein said at least one NMOS transistor further includes N+ source and drain regions implanted in said P-well at locations spaced apart from one another, a gate oxide layer applied to an upper surface region of said P-well situated between said N+ source and drain regions, and a top gate overlying said gate oxide layer.

6. The integrated circuit of claim 5, wherein said P-type laser is an epitaxial layer situated above an N+ material, said integrated circuit further comprising at least one DMOS transistor which is electrically isolated from said at least one NMOS transistor by at least one P-type isolation region and which includes an N-type feed-through region passing through said P-type epitaxial layer to electrically connect said N-type epitaxial layer with said N+ material.

7. The integrated circuit of claim 6, further comprising at least one PMOS transistor which is electrically isolated from said at least one NMOS transistor and from said at least one DMOS transistor by at least one P-type isolation region.

8. The integrated circuit of claim 7, wherein said P-type isolation regions are doped with Aluminum ions.

9. The process of forming a P-well in an N-type epitaxial layer, comprising the steps of diffusing a first, rapidly diffusing dopant and a second, less-rapidly diffusing dopant into said N-type epitaxial layer to form an effective doped P-well having a junction with said N-type epitaxial layer at a depth between the diffusion depths of said first and second dopants.

10. The process of claim 9, wherein said first dopant is Aluminum and said second dopant is Boron.

11. The process of forming a P-well in an N-type epitaxial layer above an N+ buried layer, comprising the steps of:

(a) implanting an N-type dopant in a P-type layer;

(b) depositing said N-type epitaxial layer on said P-type layer;

(c) implanting a first, rapidly diffusing P-type dopant and a second, less rapidly diffusing P-type dopant in said N-type epitaxial layer; and

(d) diffusing said N-type dopant and said P-type dopants such that a P-well is formed by diffusion of said P-type dopants in said N-type epitaxial layer and an N+ buried layer is formed by diffusion of said N-type impurity, said P-well having an effective junction depth spaced apart from said N+ buried layer to define a depletion region in said N-type epitaxial layer of sufficient depth to support a predetermined applied voltage.

12. The process of claim 11, wherein said first P-type dopant is Aluminum and said second P-type dopant is Boron.

13. A P-well comprising an N-type region of semiconductor material implanted at an energy of 100 - 200 KeV with Aluminum ions at a concentration of $4 \times 10^{13} - 7 \times 10^{13}$ cm$^{-3}$, implanted at an energy of 50-100 Kev with Boron ions at a concentration of $4 \times 10^{11} - 1 \times 10^{13}$ cm$^{-3}$, and diffused for 100 - 360 minutes at a temperature of 1100 - 1200° C.

14. An NMOS transistor comprising:

a. a layer of P-type silicon;

b. an N-type epitaxial layer deposited on said P-type layer;

c. a P-well formed in said N-type region of semiconductor material by implantation of Aluminum ions at an energy of 100 - 200 KeV and at a concentration of $4 \times 10^{13} - 7 \times 10^{13}$ cm$^{-3}$, implantation of Boron ions at an energy of 50-100 Kev and at a concentration of $4 \times 10^{11} - 1 \times 10^{13}$ cm$^{-3}$, and diffused for 100 - 360 minutes at a temperature of 1100 - 1200° C;

d. N+ regions in said P-well region forming a source and a drain, respectively; and

e. an N+ region in said N-type epitaxial region and adjacent said P-well region forming a contact to said N-type epitaxial region.

15. The NMOS transistor of claim 14, wherein said Aluminum ions and said Boron ions form an effective P-well junction with said N-type epitaxial layer at a predetermined depth, said NMOS transistor further comprising an N+ buried layer situated beneath said P-well region and having an upper boundary spaced from said effective P-well junction to define a depletion region within said N-type epitaxial layer of sufficient depth to support a predetermined reverse-bias voltage.

16. A monolithic circuit having at least one DMOS circuit element and at least one NMOS circuit element, comprising: an N+ silicon substrate; a P-type epitaxial layer deposited on said N+ silicon substrate; and an N-type epitaxial layer deposited on said P-type epitaxial layer, wherein said DMOS circuit element is formed in a first region of said substrate and said epitaxial layers, and said NMOS circuit element is formed in a second region of said epitaxial layers, said NMOS circuit element having a P-well formed in said second region of said N-type epitaxial layer by implantation and diffusion of Aluminum ions and Boron ions.

17. The monolithic circuit of claim 16, further comprising at least one PMOS circuit element formed in a third region of said epitaxial layers.

18. The monolithic circuit of one of claims 16 or 17, wherein said Aluminum ions are implanted at an energy of 100 - 200 KeV and at a concentration

of $4 \times 10^{13}$ - $7 \times 10^{13}$ cm$^{-3}$, said Boron ions are implanted at an energy of 50-100 Kev and at a concentration of $4 \times 10^{11}$ - $1 \times 10^{13}$ cm$^{-3}$, and said implanted Aluminum ions and said implanted Boron ions are diffused for 100 - 360 minutes at a temperature of 1100 - 1200°C.

EP 0 397 014 A2

FIG. I

FIG. 2

FIG.3

ALUMINUM / BORON P-WELL

SiO₂ SURFACE

Si/SiO₂ INTERFACE

NET CARRIER CONCENTRATION (P)

NET CARRIER CONCENTRATION (N)

ALUMINUM

ARSENIC

BORON

EP 0 397 014 A2

FIG. 4

Nouvellement déposé

EP 0 397 014 A2

FIG. 5

BORON P-WELL

SiO₂ SURFACE

Si/SiO₂ INTERFACE

NET CARRIER CONCENTRATION (P)

NET CARRIER CONCENTRATION (N)

BORON

ARSENIC

LOG (CONCENTRATION (#/CM**3))

DISTANCE (MICRONS)

EP 0 397 014 A2

*FIG. 6*

FIG.7

ALUMINUM / BORON P-WELL

FIG.8

EP 0 397 014 A2

FIG. 9

STANDARD P-WELL

NET CARRIER CONCENTRATION (N)

NET CARRIER CONCENTRATION (P)

BORON    ARSENIC    ANTIMONY

LOG (CONCENTRATION (#/CM**3))

DISTANCE (MICRONS)

EP 0 397 014 A2